(19) Europäisches Patentamt / European Patent Office / Office européen des brevets

(11) **EP 2 678 461 B1**

(12) **EUROPÄISCHE PATENTSCHRIFT**

(45) Veröffentlichungstag und Bekanntmachung des Hinweises auf die Patenterteilung:
**01.04.2015  Patentblatt 2015/14**

(21) Anmeldenummer: **12706517.5**

(22) Anmeldetag: **20.02.2012**

(51) Int Cl.:
*C03C 17/00* (2006.01)    *C03C 17/09* (2006.01)
*C23C 16/46* (2006.01)    *H01L 21/02* (2006.01)
*H01L 21/67* (2006.01)    *H01L 21/677* (2006.01)
*H01L 31/18* (2006.01)    *C23C 14/56* (2006.01)
*C23C 14/54* (2006.01)

(86) Internationale Anmeldenummer:
**PCT/EP2012/052860**

(87) Internationale Veröffentlichungsnummer:
**WO 2012/113750 (30.08.2012 Gazette 2012/35)**

(54) **VERFAHREN UND VORRICHTUNG ZUR BESCHICHTUNG VON SUBSTRATEN**

METHOD AND DEVICE FOR COATING SUBSTRATES

PROCÉDÉ ET DISPOSITIF POUR REVÊTIR DES SUBSTRATS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.02.2011  DE 102011004441**

(43) Veröffentlichungstag der Anmeldung:
**01.01.2014  Patentblatt 2014/01**

(73) Patentinhaber: **CTF Solar GmbH**
**01099 Dresden (DE)**

(72) Erfinder:
• **HARR, Michael**
 **65779 Kelkheim (DE)**
• **RICHTER, Hilmar**
 **61194 Niddatal (DE)**
• **BOSSERT, Steffen**
 **38471 Rühen (DE)**
• **STEUDTEN, Ralf**
 **08297 Zwönitz (DE)**
• **GEORGE, Steffen**
 **08393 Dennheritz (DE)**
• **TITTEL, Sebastian**
 **08321 Zschorlau (DE)**
• **SCHADE, Werner**
 **09221 Neukirchen-Adorf (DE)**

(74) Vertreter: **Kailuweit & Uhlemann Patentanwälte Partnerschaft mbB**
**Bamberger Straße 49**
**01187 Dresden (DE)**

(56) Entgegenhaltungen:
**EP-A1- 1 260 605    WO-A2-2010/012890**

**Beschreibung**

Die Erfindung betrifft ein Verfahren und eine Vorrichtung zur Beschichtung plattenförmiger Substrate, insbesondere von Glassubstraten für die Solarzellenherstellung.

Bei der zukünftigen Energieerzeugung werden Solarzellen eine entscheidende Rolle spielen. Insbesondere Dünnschichtsolarzellen haben dabei Vorteile im Hinblick auf geringen Materialverbrauch und ihre Eignung für eine Massenproduktion. Als Alternative zu Solarzellen auf Siliziumbasis bieten sich insbesondere Dünnschichtsolarzellen auf Cadmiumtellurid (CdTe)-Basis an. CdTe hat eine Energielücke von 1,45 eV und ist deshalb zur Absorption von Sonnenlicht gut geeignet. Entsprechend lassen sich mit CdTe-Dünnschichtsolarzellen hohe Wirkungsgrade erzielen. Normalerweise wird CdTe als Schichtstruktur mit Cadmiumsulfid (CdS) verwendet, um den notwendigen pn-Übergang herzustellen, der aus einer Doppelschicht p-CdTe-n-CdS besteht. CdS wirkt hierbei gewissermaßen als Fenster und absorbiert vom sichtbaren Licht nur einen kleinen Teil, während der Rest zum CdTe durchgelassen wird, wo schließlich die zu einer Photospannung führenden Ladungsträger erzeugt werden.

Als Substrat wird bei der Herstellung von Dünnschichtsolarzellen auf CdTe-Basis üblicherweise Glas verwendet. Vom Substrat aus beginnend werden dann in Folge der Frontkontakt, die n-CdS-Schicht, die p-CdTe-Schicht und schließlich der Rückkontakt aufgebracht. Als Frontkontakt dient dabei ein transparentes leitfähiges Oxid (TCO, transparent conductive oxide), wobei in der Regel indiumdotiertes Zinnoxid (ITO) verwendet wird. Andere bekannte TCOs sind fluordotiertes Zinnoxid (FTO) oder aluminiumdotiertes Zinkoxid (AZO). Im Folgenden wird auf die Herstellung des Frontkontakts nicht näher eingegangen.

Als Rückkontakt wird eine Metallschicht verwendet, wobei zur Erhöhung der Stabilität der Solarzelle und zur ohmschen Anpassung an die CdTe-Schicht teilweise zusätzliche Schichten eingefügt werden.

Wenn im Folgenden von Substrat die Rede ist, wird vorausgesetzt, dass die notwendigen Vorbereitungsarbeiten am Substrat, wie eben die Aufbringung des Frontkontaktes, Reinigungs- und Polierschritte etc. abgeschlossen sind.

Wenn von der Temperatur des Substrats die Rede ist, ist die Oberflächentemperatur der Unterseite, also die nach unten zeigende üblicherweise mit TCO beschichtete Seite gemeint.

Diese wird, ebenso wie die Temperatur der Oberseite, berührungslos durch Sensoren bestimmt. Dem Fachmann ist bekannt, dass diese Daten sowie weitere Daten der Vorrichtung einzeln oder gemeinsam mit den Daten vor- oder nachgeschalteter Vorrichtungen an eine oder mehrere Datenverarbeitungsanlagen übermittelt werden, die aufgrund dieser Daten die Steuerung der Einzelanlagen unter Berücksichtigung eines Gesamtprozesses erledigen. Auch das erfindungsgemäße Verfahren wird in dieser Art gesteuert.

Als geeignet zum Abscheiden des CdS und CdTe hat sich besonders das Close-Spaced-Sublimation (CSS)-Verfahren erwiesen. Dabei wird das Ausgangsmaterial, beispielsweise ein CdTe-Granulat hoher Reinheit in einem Behälter, insbesondere einem hierfür geeigneten Verdampfertiegel auf eine hohe Temperatur von ca. 600 bis 770°C aufgeheizt, um das aufzudampfende Material zu sublimieren bzw. zu verdampfen, wobei das Substrat in geringem Abstand über die Quelle hinweg geführt wird. Der Abstand zwischen der Quelle des Beschichtungsmaterials und dem Substrat beträgt dabei nur wenige Millimeter bis wenige Zentimeter. Zum Aufheizen der Verdampfertiegel können beispielsweise Widerstandsheizelemente oder IR-Strahlungselemente dienen. Die Beschichtung erfolgt normalerweise in einer Vakuumkammer bei einem Restgasdruck von $10^{-4}$ bis 10 mbar, wobei vorher ggf. mit einem Inertgas wie Stickstoff oder Argon gespült werden kann. Das Substrat selbst hat bei der Beschichtung typischerweise eine Temperatur von 480 bis 550°C, wenn herkömmliches Natron-Kalk-Glas verwendet wird. Das Glassubstrat erreicht diese Temperatur während des Transportvorganges, bei dem es eine oder mehrere Heizkammern durchläuft, bevor es die eigentliche Beschichtungskammer erreicht, in der die Abscheidung erfolgt. Grundsätzlich ist für einen hohen Wirkungsgrad eine hohe Substrattemperatur wünschenswert, da beobachtet wurde, dass unter einer Substrattemperatur von 575°C der Wirkungsgrad signifikant abnimmt. Allerdings können bei sehr hohen Substrattemperaturen nur entsprechend teure, temperaturbeständige Glassubstrate Verwendung finden. Insgesamt zeichnet sich das Verfahren durch hohe Abscheideraten von einigen $\mu$m/min aus.

Die Bewegung des Substrats durch die Heiz- und/oder Beschichtungskammern erfolgt mit Transportsystemen auf Basis von Rollen, die auf Wellen angeordnet sind. Ein Transportsystem mit durchgehenden Transportwellen für Solarzellen aus Silizium ist auch der WO 03/054975 A2 zu entnehmen, allerdings sind auf den Transportwellen keine zusätzlichen Rollen angeordnet, so dass die vergleichsweise kleinen Solarzellen mit ihrer gesamten Fläche auf den Transportwellen aufliegen. Verwendung finden diese Transportwellen in einem Ofen während eines Wärmebehandlungsprozesses. Für die Herstellung großflächiger Solarmodule durch Beschichtung von unten mit einem aufzudampfenden Material sind derartige Transportwellen ungeeignet, weil hierbei die zu bedampfende bzw. schon bedampfte Seite des Substrates vollflächig mit den Wellen in Berührung käme und somit die Beschichtung auf der gesamten Fläche beschädigt würde. Das plattenförmige Substrat hat im Stand der Technik eine typische freitragende Breite quer zur Transportrichtung von 600 mm, und wird nur auf Außenrollen bewegt. Größere Breiten sind im Zusammenhang mit der Verwendung von gewöhnlichem Natron-Kalk-Glas nicht geeignet. Als Substrat wird bevorzugt Glas eingesetzt. Glas wird häufig als Flüssigkeit gesehen, die bei Raumtemperatur eine besonders hohe Viskosität aufweist. Dementsprechend lässt sich auch nicht ohne Weiteres eine Schmelztemperatur benennen, sondern die Viskosität nimmt mit steigender Temperatur ab. Zur Beschreibung des Erweichens von Glas werden daher verschiedene Temperaturpunkte herangezogen, deren Werte über den Exponenten der dynamischen Viskosität (Zehner-Logarithmus) definiert werden.

Dokument WO2010012890 A2 offenbart ein Verfahren und eine Vorrichtung zur Beschichtung von plattenförmigen Substraten. Die Unterseite des Substrats ist gekühlt und die Oberseite des Substrats wird erhitzt.

Im Folgenden wird der Transformationspunkt Tg verwendet, der einen Viskositätsexponenten von 12,0 aufweist. Der Transformationspunkt liegt innerhalb des Transformationsbereichs mit einem Exponentenbereich von 12,0 - 13,4. Der Tg-Wert liegt bei dem verwendeten Glas bei etwa 550 - 555 °C (typische Floatglaswerte liegen im Bereich von 540 - 560 °C). Die Transformationstemperatur bezeichnet den Temperaturwert, bei dem die dynamische Viskosität des Substrats den Transformationspunkt erreicht. Der Bereich der Transformationstemperatur (Transformationstemperaturbereich) beschreibt im Folgenden den Temperaturbereich, in dem der Viskositätsexponent im Bereich von 12,0 bis 13,4 liegt.

Bei hohen Prozesstemperaturen, in der Nähe der Transformationstemperatur (bei ca. 540°C - 560°C - abhängig von der Glassorte), tritt eine plastische Verformung durch viskoses Fließen des Glases auf, welches irreversibel ist und so gering wie möglich gehalten werden sollte. Die niedrige Transformationstemperatur des Glases ist auch der Grund dafür, dass das Substrat, wenn es nur auf Außenrollen bewegt wird, gegenwärtig nicht bei höheren Temperaturen als ca. 520°C beschichtet werden kann.

Ausgehend vom oben beschriebenen Stand der Technik stellt sich daher die Aufgabe, ein Verfahren und eine Vorrichtung zur Beschichtung von Glassubstraten nahezu beliebiger Breite im CSS-Verfahren bei Temperaturen im Bereich der Transformationstemperatur vorzustellen.

Erfindungsgemäß wird die Aufgabe gelöst, indem das Verfahren nach Anspruch 1 zum Einsatz kommt. Vorteilhaft wird das Verfahren in einer Vorrichtung nach Anspruch 9 durchgeführt. Vorteilhafte Ausgestaltungen von Verfahren und Vorrichtung sind in den entsprechend rückbezogenen Unteransprüchen dargestellt.

Verfahren

Erfindungsgemäß wird das Substrat in einer Heizkammer oder einer Abfolge von Heizkammern bis in den Bereich der Transformationstemperatur des Substrats erhitzt. Parallel zur, oder im Anschluss an die Erwärmung auf Transformationstemperatur, wird die Oberseite des Substrats auf eine geringere Temperatur als die Unterseite erhitzt, wodurch ein Aufwölben des Substrats erreicht wird, das die Handhabbarkeit des Substrats auch bei Temperaturen oberhalb der Transformationstemperatur gewährleistet. Das so erwärmte Substrat, wird beschichtet. Als Beschichtungsmaterialien kommen bevorzugt CdS und/oder CdTe zum Einsatz, denkbar sind aber auch die Materialien Kupfer, Indium und Gallium für CIS- oder CIGS-Solarmodule und die Materialien Kupfer, Zink, Zinn und Schwefel für CZTS-Solarmodule.

Während der Beschichtung im CSS-Verfahren befindet sich das Substrat, wie beschrieben, oberhalb des Beschichtungsbehälters. Senkrecht oberhalb des Beschichtungsbehälters kann daher keine Stützvorrichtung für das Substrat vorgesehen werden, da diese die Beschichtung stören und selbst in unerwünschter Weise beschichtet würde. Das Substrat würde in dieser Position, da es eine Temperatur oberhalb der Transformationstemperatur aufweist, zu stark durchhängen und die Beschichtung ungleichmäßig ausfallen. Erfindungsgemäß wird dies vermieden, indem die Unterseite des Substrats auf eine höhere Temperatur als die Oberseite erhitzt wird. Dadurch dehnt sich vorteilhaft die stärker erwärmte untere Substratseite stärker aus als die obere, so dass eine innere Spannung im Substrat entsteht, die einer Durchbiegung entgegenwirkt.

Das Substrat ist bevorzugt rechteckig geformt. In einer weiteren bevorzugten Ausführungsform ist das Substrat quadratisch. Bei einer mehrfachen Unterstützung des Substrats, vor und hinter einem Beschichtungsbehälter, wird die nach unten gerichtete Wölbung des Substrats abgefangen und die erreichbare Stützweite ist ausreichend, um die Behälterbreite bei tolerierbarer Durchbiegung zu überbrücken.

Die Transformationstemperatur des Substrats ist von dem eingesetzten Material abhängig. Es wird bevorzugt herkömmliches Natron-Kalk-Glas als Substrat eingesetzt, dessen Transformationstemperatur zwischen 540°C bis 560°C liegt.

Die Temperatur der Unterseite des Natron-Kalk-Glas-Substrats ist bei der Beschichtung größer als 520°C und liegt vorzugsweise zwischen 540°C und 570°C und besonders bevorzugt bei ca. 550°C.

Die Temperaturdifferenz zwischen Unterseite und Oberseite des Natron-Kalk-Glas-Substrats beträgt bevorzugt mindestens 2 K bis 4 K, weiterhin bevorzugt 5 K bis 8K und besonders bevorzugt ca. 6 K. Untersuchungen mit den Natron-Kalk-Glas-Substraten haben gezeigt, dass bei typischen Prozessbedingungen (Prozessdauer 10 min, Prozesstemperatur 550°C, Glasdicke ca. 3,2 mm) die Verformungen des Glassubstrates das tolerierbare Maß nicht überschreiten, wenn die freie Stützweite ca. 300 mm bis 400 mm, bevorzugt 350 mm nicht übersteigt.

Diese vorteilhafte Vorgehensweise ermöglicht es, Arbeitsschritte, die bei Temperaturen im Bereich der Transformationstemperatur durchzuführen sind, abzuschließen, bevor aufgrund der Wärmeleitung ein Temperaturausgleich zwischen den beiden Seiten des Substrats stattgefunden hat.

Nach dem Beschichtungsvorgang wird das Substrat langsam abgekühlt. Dies ist notwendig, um Spannungen im Substrat zu vermeiden. Auch die Haftung der aufgedampften Schichten auf dem Substrat wird bei langsamer Abkühlung nicht beeinträchtigt.

In einer bevorzugten Ausführungsform liegt während des Aufbringens einer Schicht die mittlere Substrattemperatur, mit der erfindungsgemäßen Temperaturdifferenz zwischen Ober- und Unterseite des Substrats, im Bereich der Transformationstemperatur des Substrats und wird nach dem Aufbringen einer Schicht unter den Bereich der Transformationstemperatur abgekühlt. Anschließend wird es erneut erwärmt und die erfindungsgemäße Temperaturdifferenz zwischen Oberseite und Unterseite wieder hergestellt. Darauf folgt ein weiterer Beschichtungsschritt.

Während des Beschichtens wird das Substrat über Behälter mit Beschichtungsmaterial geführt. Diese Behälter weisen eine Temperatur auf, die höher als die Temperatur der Unterseite des Substrats ist. Aufgrund der Wärmeleitung im Substrat kommt es zu einer, wenn auch langsameren, Erwärmung durch das gesamte Substrat bis zur Rückseite. Die Spannung im Substrat würde somit nachlassen. Um jedoch die erfindungsgemäße Temperaturdifferenz aufrecht erhalten zu können, muss daher das Substrat zwischen den Behältern abgekühlt werden. Dazu wird bewusst ein Temperaturgradient durch das Substrat erzeugt, so dass die Substratunterseite weiterhin auf der für die Beschichtung notwendigen Prozesstemperatur gehalten wird, ohne zu überhitzen. Dies wird durch die erfindungsgemäße Vorrichtung des Heizsystems inkl. der inneren Kammern (Tunnel) und deren Regelung bzw. Steuerung erreicht. Die Einstellungen des Heizsystems sind von der Wärmeleitung des Substrats von Unterseite zu Oberseite abhängig. Bevorzugt sind die Behälter in Transportrichtung paarweise hintereinander, mit einem großen Abstand zwischen den Behälterpaaren, angeordnet. Dieser große Abstand beträgt vorzugsweise ca. 385 mm. Bei einem größeren Abstand der Behälter zueinander ist es möglich das Substrat unter die Transformationstemperatur abzukühlen. Vor dem nächsten Beschichtungsschritt muss die mittlere Substrattemperatur dann wieder durch das erfindungsgemäße Heizverfahren auf die Transformationstemperatur gebracht werden. Dieses Vorgehen verhindert, dass mit dem Temperaturausgleich zwischen Ober- und Unterseite auch die Aufwölbung und damit die Handhabbarkeit des Substrats verloren geht. Diese wird durch die zwischenzeitliche Abkühlung und erneute Erwärmung wiederhergestellt.

Während des Verfahrens werden Transportsysteme eingesetzt, bei denen das Substrat auf Rollen aufliegt. In den Teilen, des Substrats, wo es aufliegt, kommt es zu beschädigten Beschichtungsbereichen. Die Beschichtung ist in diesen Bereichen nicht vollständig oder die Schichtfolge ist durch mechanische Einwirkung gestört. Derartige Bereiche beeinträchtigen die ordnungsgemäße Funktionsweise der Solarzelle und müssen daher eliminiert werden. Dies geschieht entweder, indem die fehlerhafte Beschichtung in diesen Bereichen vorteilhaft per mechanischem Ritzen, Laserablation, Sandstrahlen oder Abschleifen bis zum Substrat entfernt wird oder, indem die beschädigten Beschichtungsbereiche von den unbeschädigten getrennt, und damit isoliert werden. Das wird bevorzugt durch Laserablation erreicht.

Zur Durchführung des erfindungsgemäßen Verfahrens wird das Substrat vorzugsweise durch eine oder mehrere Heizkammern steigender Temperatur bewegt, bis die notwendige Temperatur für die Beschichtung erreicht ist. Bis zu dem Bereich, in dem das Substrat die Transformationstemperatur überschreitet, also unterhalb 540 °C, wird es vorteilhaft auf Transportwellen mit zwei Außenrollen und wenigen Innenrollen (vorzugsweise mit einer Innenrolle bei einer Substratbreite von 1200 mm) bewegt. Innenrollen sind dabei das Substrat stützende Rollen, die zwischen zwei Außenrollen auf einer gemeinsamen Welle mit diesen angeordnet sind. Spätestens in der letzten Kammer vor der Beschichtung erreicht das Substrat den Bereich der Transformationstemperatur und die Wellen des Transportsystems weisen bevorzugt weitere Innenrollen auf (vorzugsweise insgesamt drei Innenrollen bei einer Substratbreite von 1200 mm). Es werden Oberseite und Unterseite des Substrats mit Heizsystemen für die Ober- und die Unterseite unterschiedlich stark erwärmt. Dies erfolgt bevorzugt durch eine getrennte Regelung bzw. Steuerung der Heizsysteme für die Ober- und die Unterseite. Die Temperaturen von Ober- und Unterseite werden bevorzugt durch Sensoren (vorzugsweise berührungslos messende Pyrometer) überwacht. Das Substrat wölbt sich leicht auf und kann dadurch den größeren Wellenabstand beim Übergang aus der Heizkammer in die nachfolgende Beschichtungskammer stoßfrei überbrücken bzw. in der Beschichtungskammer ohne zusätzliche Stützvorrichtung über die Beschichtungsbehälter gebracht werden.

Das Verfahren wird bevorzugt zur Herstellung von CdS/CdTe-Dünnschichtsolarzellen eingesetzt.

Während der Beschichtung beträgt der Abstand des Substrats zu den Behältern, aus denen das aufzudampfende Material sublimiert/verdampft wird, bevorzugt ca. 3 mm bis 50 mm, besonders bevorzugt 5 mm bis 20 mm. Der Abstand sollte bei dem CSS-Verfahren so klein wie möglich gehalten werden. Im Stand der. Technik sind auch Abstände von weniger als 5 mm beschrieben. Dabei wird zunächst eine CdS-, anschließend eine CdTe-Schicht aufgebracht. Entsprechend wird das Substrat zunächst über Verdampfertiegel, die CdS enthalten, und anschließend über Verdampfertiegel, die CdTe enthalten, bewegt. Die Beschichtung mit beiden Materialien erfolgt somit bevorzugt unmittelbar nacheinander in einem Prozess.

In einer weiteren bevorzugten Ausführungsform erfolgt die Beschichtung mit CdS in einer Beschichtungskammer und nachfolgend in einer zweiten Beschichtungskammer mit CdTe. In einer gleichfalls bevorzugten Ausgestaltung wird dabei eine Abkühlung des Substrats zwischen den beiden Beschichtungsschritten vorgenommen. Diese Zwischenabkühlung erfolgt in einer oder mehreren Heizkammern die zwischen den Beschichtungskammern angeordnet sind. Durch die Trennung der beiden Beschichtungsschritte wird vorteilhaft eine höhere Durchlaufgeschwindigkeit möglich, wobei der Schritt der Zwischenkühlung dafür sorgt, dass das Substrat nicht zu stark erweicht und dass durch eine erneute Aufheizung die stabilisierende Aufwölbung in der beschriebenen Art und Weise wiederhergestellt werden kann.

Abschließend durchlaufen die Substrate eine oder mehrere Heizkammern, die als Kühlzone arbeiten, in der sie zunächst vorzugsweise langsam, nach Unterschreiten einer Temperatur, die je nach Glassorte zwischen ca. 400°C und 500°C liegt, dann schneller abgekühlt werden können.

Wie auch beim eingangs beschriebenen Stand der Technik ausgeführt, erfolgt die Beschichtung vorzugsweise im Vakuum, möglich ist jedoch grundsätzlich auch eine Beschichtung bei höheren Drücken, bis hin zum Normaldruck.

Das erfindungsgemäße Verfahren wird bevorzugt zur Beschichtung von Substraten, die eine größere Breite quer zur Transportrichtung aufweisen als herkömmliche Substrate einer Breite von 600 mm, verwendet. Entsprechend können plattenförmige Substrate mit einer Breite > 700 mm, vorzugsweise > 1000 mm und besonders bevorzugt mit einer Breite von ca. 1200 mm beschichtet werden. Grundsätzlich ist jedoch die Beschichtung von Substraten nahezu beliebiger Breiten denkbar, sofern die freie Stützweite zwischen zwei Rollen nicht über das für die gewählte Prozesstemperatur und den Substratwerkstoff akzeptable Maß hinausgeht.

Vorrichtung

Die erfindungsgemäße Vorrichtung weist mindestens eine als Vakuumkammer ausgebildete Heizkammer mit mindestens zwei unabhängig voneinander steuer- oder regelbaren Heizsystemen in einer inneren Kammer auf. Mindestens ein Heizsystem erhitzt die Oberseite und mindestens ein Heizsystem erhitzt die Unterseite des Substrats. Jedes Heizsystem weist ein oder mehrere Heizelemente auf. Die Heizsysteme sind so eingestellt, dass die Unterseite des Substrats eine höhere Temperatur aufweist, als die Oberseite. Darüber hinaus weist die Vorrichtung mindestens eine ebenfalls als Vakuumkammer ausgebildete und einer Heizkammer in Transportrichtung nachgeordnete Beschichtungskammer, sowie ein Transportsystem für das Substrat, dass sich durch die Heizkammer und ein Transportsystem für das Substrat, dass sich durch die Beschichtungskammer erstreckt. Beide Transportsysteme weisen mehrere, parallele, axial beabstandete, in Transportrichtung hintereinander und senkrecht zu dieser Transportrichtung, angeordnete Wellen auf. Die Transportgeschwindigkeit des Substrats in den Transportsystemen beträgt bevorzugt zwischen 0,5 m/s und 5 m/s, besonders bevorzugt zwischen 1 m/s und 4 m/s und weiterhin besonders bevorzugt zwischen 1,5 m/s und 3 m/s.

Die als Vakuumkammer ausgeführte Heizkammer weist eine innere Kammer auf, die vorteilhaft beabstandet von der inneren Wandung der Heizkammer ist. Die Außenseite der inneren Kammer ist bevorzugt mit einer Temperaturdämmung versehen. Nach innen folgen dann die Heizsysteme und die innere Wandung der inneren Kammer. Die Heizsysteme sind also zwischen Wärmedämmmaterial und der inneren Wandung angeordnet. Dies dient der thermischen Gleichverteilung der Wärmeabgabe des Heizsystems, indem die innere Wandung der inneren Kammer einen Tunnel bildet, der die von den Heizsystemen abgestrahlte Wärme diffus auf das Substrat verteilt und praktisch als indirekter Heizer bezogen auf das Substrat wirkt. Mittels der thermischen Isolierung wird eine direkte Abstrahlung der Wärme des Heizsystems an die Wandung der Heizkammer unterbunden. Durch die innere Kammer und die gesamte Heizkammer führt ein Transportsystem, dass eine Mehrzahl von Wellen zur Bewegung des Substrats aufweist, die durch die Wandung hindurchgeführt und außerhalb der inneren Kammer gelagert sind.

Als Material für die innere Wandung der inneren Kammer kommt bevorzugt ein Metall, wie bspw. Molybdän (bzw. eine Molybdänlegierung) zum Einsatz. Weitere bevorzugte Ausführungsformen sehen Quarz oder Kohlenstoffverbundmaterial vor.

Die Oberflächentemperatur der Unterseite des Substrats wird bevorzugt berührungslos über Sensoren erfasst. In einer bevorzugten Ausführungsform sind die Sensoren außerhalb der Heizkammer angeordnet und erfassen die Temperaturwerte des Substrats durch kleine Bohrungen, die durch den gesamten Aufbau hindurch reichen. Das Heizsystem ist vorteilhaft regelbar. Die erfassten Daten der Temperatursensoren sowie andere Informationen der Vorrichtung (bspw. Vorschubgeschwindigkeit und Position des Substrats) werden ebenfalls erfasst und an eine zentrale Datenverarbeitungseinrichtung übermittelt, die die Steuerung der Vorrichtung vornimmt und auf die nicht näher eingegangen wird. Das Heizsystem weist eine oder mehrere Heizschlangen auf, die bevorzugt als Widerstandsheizung ausgebildet sind. Die Heizschlangen sind dabei einzeln oder in Gruppen in Schleifen-, Zick-Zack- oder Mäanderform oder in einer anderen aus dem Stand der Technik bekannten Verlegeweise zwischen den Wellen angeordnet. Jede Heizschlange dieser Gruppen von Heizschlangen kann individuell in seiner Temperatur geregelt werden. Unter und über dem Heizsystem und bevorzugt mit seitlich abgewinkeltem Überstand sind Reflexionsbleche angeordnet, die die abgestrahlte Wärme in Richtung des Substrats reflektieren. Durch den seitlichen Überstand wird auch die seitliche Kante des Substrats mit erwärmt. Nur durch die erfindungsgemäße Anordnung von Heizsystemen und innerer Kammer und der gezielten Ansteuerung der Heizsysteme ist es möglich, das Substrat von unten zu beschichten und durch geringere Aufheizung oder sogar Abkühlen der Glasoberseite die erforderliche Prozesstemperatur an der Glasunterseite zu halten. Dazu erzeugen die oberen Heizsysteme bevorzugt eine um ca. 10 K geringere Temperatur als die unteren Heizsysteme,

Die Wellen des Transportsystems sind in Transportrichtung hintereinander und axial beabstandet zueinander sowie senkrecht zur Transportrichtung angeordnet. Dabei sind die Wellen horizontal angeordnet, wobei vorzugsweise in Transportrichtung in der Abfolge der Wellen kein oder nur ein sehr geringes Gefälle (bevorzugt < 3 %) auftritt.

Die Wellen werden vorzugsweise mittels Durchführungen aus der inneren Kammer herausgeführt und außerhalb dieser gelagert. Auch der Antrieb der Wellen ist bevorzugt außerhalb der beheizten inneren Kammer, jedoch im Vakuum angeordnet. Der Antrieb erfolgt bevorzugt mittels einer direkten mechanischen Verbindung zur Welle, beispielsweise, indem ein Motor, dessen Getriebe oder ein Kettenantrieb direkt an mindestens einem Wellenende ansetzt. In der inneren Kammer, sind zwischen den Durchführungen und dicht beabstandet zu ihnen, je Welle zwei Außenrollen angeordnet. Zwischen den Außenrollen ist jeweils mindestens eine Innenrolle angeordnet. Die Außenrollen weisen bevorzugt konische Auflageflächen für das Substrat mit zum nächstgelegenen Wellenende hin zunehmendem Durchmesser auf. Bevorzugt sind die Außenrollen mit geneigten Führungsbünden ausgestattet. Die Wellen, bei denen die Unterseitentemperatur des Substrats über einer Transformationstemperatur des Substrats liegt, weisen bevorzugt zwei oder mehr Innenrollen auf. Vorzugsweise weisen die Außenrollen dieser Wellen einen größeren Abstand der Führungsbünde auf, als Wellen, bei denen die Unterseitentemperatur des Substrats unter der Transformationstemperatur liegt.

Da das Substrat auf einer Mehrzahl von Rollen transportiert wird, ist es notwendig zu verhindern, dass die in Transportrichtung vordere Kante des plattenförmigen Substrats beim Erreichen der nächsten Welle durchhängt und einem Stoß beim Übergang auf die nächste Welle ausgesetzt wird. Dies könnte zu einer Beschädigung der Kante führen. Dem Phänomen könnte dadurch begegnet werden, dass die Abstände der Wellen verringert werden. Problematisch dabei ist jedoch, dass der dann zur Verfügung stehende Zwischenraum zwischen zwei Wellen nicht mehr ausreicht, um den notwendigen Einbauten wie bspw. den Verdampfertiegeln Platz zu bieten. Auch bei einem Übergang des Substrats von einer Kammer zu einer anderen ist es notwendig, einen größeren Wellenabstand ohne starkes Durchhängen der Vorderkante des Substrats zu überbrücken.

Um dieses Problem zu lösen wird durch geeignete Steuerung bzw. Regelung der Heizsysteme die Unterseite des Substrats stärker erwärmt als die Oberseite. Bereits kleine Temperaturunterschiede zwischen Ober- und Unterseite führen über die resultierende unterschiedliche thermische Ausdehnung beider Seiten zu einer elastischen Verbiegung des Substrats. Dies bewirkt, dass die Ränder des Substrats höher liegen als die Mitte. Gleichzeitig unterliegt das Substrat der Schwerkraft. Bei Lagerung des Substrats auf Außenrollen, die lediglich an den Rändern angeordnet sind, bewirkt die Schwerkraft eine Verbiegung des Substrats, die in die gleiche Richtung weist, wie die thermisch bedingte Verbiegung. Die beiden Vorgänge verstärken sich somit gegenseitig. Wenn jedoch zusätzlich zur Lagerung am Rand durch die Außenrollen noch eine Lagerung in der Mitte der Scheibe durch eine oder mehrere Innenrollen hinzutritt, bewirkt die Abstützung der Scheibe auf den Innenrollen, dass die thermische Verbiegung der Ränder des Substrats nach oben durch die nach unten gerichtete Schwerkraft mindestens teilweise kompensiert wird, so dass sich die resultierende Gesamtverbiegung verringert.

Auch die Beschichtungskammer ist als Vakuumkammer ausgeführt und weist eine innere Kammer zur thermischen Gleichverteilung auf. Das Transportsystem, das sich durch die gesamte Beschichtungskammer erstreckt, übernimmt die Substratscheiben von dem Transportsystem der vorgeschalteten Heiz- oder Beschichtungskammer und übergibt sie an das Transportsystem der nachgeschalteten Heiz- oder Beschichtungskammer. Während des Transportes durch die innere Kammer werden die Substratscheiben an ihrer Unterseite beschichtet. Die Beschichtungsmaterialien (bevorzugt CdS oder CdTe) sind in beheizten, nach oben geöffneten Behältern (Verdampfertiegeln) angeordnet, über die das Substrat in geringem Abstand hinweg geführt wird. Direkt oberhalb der Behälter sind vorteilhaft keine Transportrollen angeordnet, um ein unerwünschtes Beschichten der Transportrollen zu vermeiden oder weitgehend zu reduzieren. Wenigstens einige der Wellen des Transportsystems weisen daher einen größeren Abstand zueinander auf, als dies in der Heizkammer der Fall war. Der Aufbau der Wellen entspricht dem der Wellen des Transportsystems in der Heizkammer. Da das Substrat die Beschichtungskammer mit einer Temperatur im Bereich der Transformationstemperatur durchläuft, verfügen die Wellen über mehr Innenrollen und einen größeren Abstand der Führungsbünde als die Wellen, bei denen die Substrattemperatur unterhalb der Transformationstemperatur liegt. Ein Heizsystem ist in der Beschichtungskammer lediglich oberhalb des Transportsystems vorgesehen. Da die Temperatur der Behälter deutlich höher als die Temperatur der Substratunterseite ist, wird von daher auch eine Heizwirkung auf der Unterseite des Substrates erzielt. Die Temperatur des Substrats muss allerdings deutlich niedriger als die Temperatur in den Behältern sein, um ein Niederschlagen der verdampften bzw. sublimierten Stoffe auf der Substratunterseite zu erreichen. In einer bevorzugten Ausführungsform werden auch in der Beschichtungskammer die Temperaturen von Ober- und Unterseite des Substrats durch Sensoren erfasst.

Die Sensoren in Heiz- und Beschichtungskammer arbeiten bevorzugt berührungslos und erfassen die Temperatur der Substratoberflächen bevorzugt aufgrund der Abstrahlung von der Oberfläche (bspw. pyrometrische Sensoren).

Die Übergabe des Substrats von dem Transportsystem einer Kammer zum Transportsystem der folgenden Kammer erfolgt durch Zufuhrschlitze, mit denen die Kammern untereinander in Verbindung stehen. Eine Druckschleusung findet lediglich zur Zufuhr des Substrats in die erste Kammer und zur Entnahme aus der letzten Kammer statt.

Die Transportwellen der Transportsysteme bestehen vorzugsweise aus Quarz-Keramik (Fused Silica). Dieses Material zeichnet sich durch eine sehr geringe Wärmeleitung und hohe mechanische Steifigkeit auch bei hohen Temperaturen aus. Die einzelnen Rollen können vorzugsweise durch einen Schleifprozess aus den zunächst zylindrischen Wellen durch selektive Reduktion des Durchmessers in Bereichen außerhalb der Rollen herausgearbeitet werden. Dabei ist es ausreichend, wenn die Rollen lediglich geringfügig, bevorzugt weniger als 10 mm, über die eigentliche Transportwelle hinaus stehen. Durch die geringe Wärmeleitung der bevorzugt verwendeten Quarz-Keramik ist es möglich, die Enden der Transportwellen auf beiden Seiten vorteilhaft mit Edelstahlkappen zu versehen. Die Transportwellen werden mittels der Edelstahlkappen beidseitig in Lagern geführt, wobei der Antrieb bevorzugt einseitig über einen Zahnradmechanismus erfolgt. Die Ausdehnung einer Transportwelle aus Quarz-Keramik bei hoher Temperatur ist sehr gering und kann daher vernachlässigt werden.

Vorzugsweise sind erfindungsgemäß auch die Innenrollen auf der gleichen Transportwelle angeordnet, wie die in einer Linie quer zur Transportrichtung des Substrats liegenden Außenrollen. Bevorzugt sind die Innenrollen von in Transportrichtung aufeinanderfolgenden Wellen fluchtend angeordnet. Sämtliche Rollen können in diesem Fall aus der Transportwelle herausgearbeitet werden. Dies geschieht bevorzugt durch Schleifen, Drehen oder ein anderes Bearbeitungsverfahren nach dem Stand der Technik. Das Ziel eines ruhigen Laufes wird allerdings bereits weitgehend erreicht, wenn lediglich die Außenrollen auf einer durchgehenden Transportwelle sitzen, so dass auch die Anordnung der Innenrollen auf einer oder mehreren gesonderten Wellen möglich ist oder eine lose Lagerführung der Innenrollen auf der Welle, ohne dass die Innenrollen mit angetrieben würden.

In einer bevorzugten Ausführungsform werden lediglich einige Transportwellen angetrieben, um das Substrat vorwärts zu bewegen, während andere Transportwellen mit den hierauf angeordneten Rollen lediglich der Stützung des Substrats dienen.

Bevorzugt werden in einer Abfolge von Heiz- und Beschichtungskammern Transportsysteme eingesetzt die nur zwei bevorzugte Bauformen von Wellen aufweisen:

- für Bereiche, in denen die Temperatur nahe zur oder im Bereich der Transformationstemperatur liegt, verfügen die Wellen über mehr Innenrollen und einen größeren Abstand der Führungsbünde. Der Abstand der Führungsbünde beträgt bevorzugt 1205 mm bis 1207 mm, besonders bevorzugt 1206 mm und die laterale Pendelbewegung der Substratscheibe wird so vorteilhaft auf ca. $\pm 1$ mm beschränkt.

- für Bereiche, in denen die Temperatur unterhalb der Transformationstemperatur liegt, verfügen die Wellen über einen einheitlichen Abstand der Führungsbünde (bevorzugt 1205 mm) und weisen bevorzugt nur eine (vorzugsweise mittige) Innenrolle auf. Die laterale Pendelbewegung der Substratscheibe wird im Bereich von 25°C bis ca. 500°C auf $\pm 2{,}5$ mm begrenzt. Die Zahl der Innenrollen kann höher liegen, wenn die Substratbreite eine weitere Stützung erfordert. Dann erhöht sich die Zahl der Innenrollen für Wellen im Temperaturbereich oberhalb der Erweichungstemperatur ebenfalls.

Die Verwendung von lediglich zwei Bauformen von Wellen führt vorteilhaft zu deutlichen Kostenvorteilen aufgrund der erhöhten Produktionsstückzahlen je Bauform.

Dadurch, dass die Außenrollen auf einer durchgehenden Welle mit einer ausreichend hohen Torsionssteifigkeit angeordnet sind, laufen die Außenrollen stets synchron, so dass sich ein Schlupf aufgrund unterschiedlich langer Übertragungswege nicht mehr ausbilden kann.

Die konischen Auflageflächen der Außenrollen weisen im Schnitt bevorzugt einen Winkel von 0,3° bis 6°, besonders bevorzugt von 0,6° bis 4° und weiterhin besonders bevorzugt von 1° bis 2° auf. Der Lauf des Substrats über die Rollen ist dadurch erheblich ruhiger und gleichmäßiger. Vorzugsweise weisen die Führungsbünde der Außenrollen eine Neigung auf, die eine seitliche Führung des Substrats bewirkt, ohne eine zu große Kantenbeanspruchung hervorzurufen, die zu Kantenbeschädigungen führen könnte. Der Winkel der Führungsbünde im Schnitt der Welle gemessen beträgt zwischen 120° und 150°, bevorzugt zwischen 130° und 142° und besonders bevorzugt 139°.

In einer alternativen bevorzugten Ausführungsform der Außenrollen werden keine Führungsbünde vorgesehen und eine Führung des Substrats im Transportsystem wird durch seitliche Führungsrollen vorgenommen, die federnd gelagert sind und einen führenden Gegendruck erzeugen, falls die Substratkante seitlich von der Transportrichtung abweicht.

Besonders vorteilhaft ist die Vorrichtung für die Verarbeitung von preisgünstigem Natron-Kalk-Glas verwendbar, welches einen vergleichsweise niedrigen Erweichungspunkt hat. Selbstverständlich kann die Vorrichtung auch zur Beschichtung anderer Substrate angewendet werden, beispielsweise für Gläser, die eine höhere Temperaturbeständigkeit aufweisen. Es ist möglich, Substrate nahezu beliebiger Breite zu beschichten, solange eine entsprechende Anzahl an Innenrollen in geeignetem Abstand eingesetzt wird. Entsprechend können beispielsweise auch Glassubstrate einer Breite von 1200 mm und größer zum Einsatz kommen.

Bei der Beschichtung des bevorzugten Natron-Kalk-Glas-Substrats einer Dicke von 3,2 mm und einer Temperatur von ca. 550°C ergibt sich eine mögliche freie Stützweite von ca. 350 mm. Der Abstand zweier Rollen sollte somit 300 mm bis 400 mm, bevorzugt 350 mm betragen. Darüber hinaus hat sich gezeigt, dass sich beispielsweise ein 1200 mm breites Substrat bei Lagerung auf zwei Außenrollen und einer Mittelrolle zwischen den Rollen weniger stark durchbiegt als bei einem 600 mm breiten Substrat, das nur auf zwei Außenrollen liegt, obwohl in beiden Fällen die freie Spannweite jeweils 600 mm beträgt. Der Grund hierfür ist darin zu sehen, dass die Biegelinie einer nur auf zwei am äußeren Rand angreifenden Rollen gelagerten, als Substrat dienenden Scheibe die Horizontale unter einem bestimmten Winkel schneidet, hingegen die Biegelinie einer zusätzlich durch eine Mitterolle unterstützten Scheibe an dieser stetig verlaufen muss und deshalb aus Symmetriegründen der Winkel gegen die Horizontale am Ort der Mittelrolle verschwindet. Diese vorteilhafte erfindungsgemäße Vorgehensweise gestattet es, den Abstand der Wellen für das obengenannte Substrat und die erwähnten Prozessbedingungen von üblichen ca. 230 mm auf ca. 350 mm zu erhöhen.

Durch die Verringerung der Verbiegung des Substrats wird es möglich, die Beschichtung bei höherer Temperatur als 520°C durchzuführen, vorzugsweise zwischen 540 und 560°C, besonders bevorzugt bei ca. 550°C.

Vorteilhaft führt die Abscheidung von CdS/CdTe bei einer Temperatur von ca. 550°C im Vergleich zur Anwendung niedrigerer Temperaturen zu einer Erhöhung des Wirkungsgrades der fertigen Solarzelle. Hierbei wird zwar in Kauf genommen, dass die Beschichtung des Substrats im Bereich der Laufspur der Innenrollen beschädigt wird. Die gestörte CdS/CdTe-Schicht weist im Bereich der Innenrollen eine Breite von < 12mm, sowie im Bereich der Außenrollen eine Breite von < 10mm auf. Durch die Hinzuziehung weiterer Innenrollen erst ab der Transformationstemperatur beträgt die Breite des zerstörten Beschichtungsbereichs für die zusätzlichen Innenrollen lediglich ca. 6 mm, da bei Temperaturen im Bereich der Transformationstemperatur die Substratführung, wie dargestellt, sehr eng ist und somit eine "Schwimmen", d .h. eine laterale Bewegung des Substrats reduziert wird. Die beschädigten Bereiche müssen im Rahmen eines späteren Prozessschrittes entfernt werden. Die hierdurch bedingte Reduzierung der aktiven Fläche des Produktes wird jedoch durch die höhere Prozesstemperatur und den daraus resultierenden höheren Wirkungsgrad überkompensiert. Typischerweise wird in einem auf die Beschichtung folgenden Arbeitsschritt die CdS/CdTe-Schicht im Kontaktbereich mit den Rollen, z. B. durch Laserablation, wieder entfernt. Möglich ist auch die Entfernung der Beschichtung durch Sandstrahlen oder mechanisches Ritzen. Alternativ kann der beschädigte Schichtbereich auch durch zwei dünne Isolierschnitte abgetrennt werden, die die Beschichtung durchdringen, jedoch nur geringfügig in das Substrat einschneiden. Eine mögliche Breite für derartige Isolierschnitte beträgt 20 $\mu$m bis 100 $\mu$m. Bei nur geringfügiger Beeinträchtigung der photovoltaischen Qualität durch die Rollen kann u. U. auch auf die Behandlung der Kontaktbereiche vollständig verzichtet werden. Dies wird bevorzugt während des Arbeitsschrittes der Klassifizierung des Substrats entschieden. Es muss somit ein technisch sowie wirtschaftlich sinnvoller Kompromiss zwischen erwünschter hoher Prozesstemperatur einerseits und unerwünschtem Flächenverlust andererseits gefunden werden.

Auslegungsbeispiel zur Größe des gestörten Beschichtungsbereiches

Nachfolgend wird beispielhaft ermittelt, mit welchen Störungen in der Beschichtung des Substrats bei der Durchführung des erfindungsgemäßen Verfahrens mit der erfindungsgemäßen Vorrichtung zu rechnen ist.

Das plattenförmige Glassubstrat weist beispielsweise eine Länge von 1600 mm, eine Breite von 1200 mm und eine Dicke von 3,2 mm auf. Bevorzugt beträgt die Breite der Innenrollen 2 mm bis 6 mm, insbesondere 3 mm bis 5 mm. Eine möglichst schmale Rollenbreite ist vorteilhaft, da auf diese Weise der durch die Rollen beschädigte Bereich, in dem später die Beschichtung wieder entfernt werden muss, schmal gehalten wird. Bei zentrierter Scheibe wird der durch die Mittelrolle beschädigte Bereich durch die Rollenbreite zuzüglich der doppelten Führungstoleranz $l_{\text{führ,tol}}$ und der Maßtoleranz $l_{\text{Maß,tol}}$ des Substrates bestimmt. Um gerade in diesem Bereich den zerstörten Bereich klein zu halten, kann die Rollenbreite der Innenrollen, d. h. der Mittel- oder Zwischenrollen, kleiner gewählt werden als die der Außenrolle.

Beispielsweise beträgt die Rollenbreite innen 3,0 mm, die Breite der Auflageflächen der Außenrollen hingegen 5,0 mm. In diesem Fall ergibt sich bei einer Führungstoleranz der Scheibe von $\pm 0,5$ mm und einer Maßtoleranz der Scheibe von $\pm 0,5$ mm somit eine maximale Breite des zerstörten CdTe-Streifens von 5 mm bei den Innenrollen.

Wählt man, wie oben bereits beschrieben, eine Transformationstemperatur $T_G$ derart, dass im Bereich der Transformationstemperatur eine Transportwelle mit $n_{\text{ober}}$ Rollen, unterhalb der Transformationstemperatur hingegen eine Transportwelle mit $n_{\text{unter}}$ Rollen verwendet wird, muss zusätzlich die Beschädigung der Beschichtung durch die zusätzlichen Rollen berücksichtigt werden. Bei $T_G$ = 500°C beträgt die Längenausdehnung des Glassubstrats zwischen 25 °C und 500°C $dL_{25\_500}$ ca. 5 mm und die Längenausdehnung zwischen 25 °C und 550°C $dL_{25-550}$ ca. 6 mm. Der durch die Außenrollen zerstörte CdTe-Bereich hat daher eine Breite von

$$b_{\text{CdTe,außen}} = b_{\text{Rolle,außen}} + dL_{25-500}/2 + 2^*(l_{\text{führ,tol}} + l_{\text{Maß,tol}}) \approx 9,5\,\text{mm}$$

(Breite der Außenrolle $b_{\text{Rolle,außen}}$ = 5 mm).

Der durch die zusätzlichen Zwischenrollen zerstörte CdTe-Bereich hat eine Breite von

$$b_{CdTe,zwischen} = b_{Rolle,innen} + (dL_{25-550} - dL_{25-500})/4 + 2*(l_{führd} + l_{Maßtol}) \approx 5,25 \text{ mm}$$

(Breite der Zwischenrolle $b_{Rolle,innen}$ = 3 mm).

Ausführungsbeispiel

Nachfolgend wird eine beispielhafte Vorrichtung beschrieben, die zur Durchführung des erfindungsgemäßen Verfahrens geeignet ist. Die Bezugzeichen verweisen auf die entsprechenden Elemente in den Figuren.

Eine erste Heizkammer (3), eine Beschichtungskammer (2) und eine zweite Heizkammer (3) sind hintereinander angeordnet.

Es kommt ein plattenförmiges Substrat (1) aus Natron-Kalk-Glas mit einer Transformationstemperatur von 550°C zum Einsatz. In einem vorhergehenden Arbeitsschritt wurde bereits auf der Unterseite des Substrats (1) eine TCO-Schicht als Frontelektrode aufgebracht. Die Breite des Substrats (1) in Transportrichtung beträgt bei 25°C 1200 mm. Die Länge des Substrats (1) beträgt 1600 mm (bei 25°C). Die Substratkante ist im C-Schliff abgerundet. Das Substrat (1) tritt in die erste Heizkammer (3) mit einer Temperatur von 480°C ein. Es wird auf einem Transportsystem (30) bewegt. Das Transportsystem (30) besteht aus Wellen (31), die Außenrollen (313) mit geneigten Führungsbünden (3132) aufweisen. Die Neigung des Führungsbundes (3132) jeder Außenrolle (313) beträgt in einem durch die Wellenachse gelegten Schnitt 139°. Der Abstand der Führungsbünde (313) beträgt 1205 mm. Das Substrat liegt an den zur Transportrichtung parallelen Kanten auf den Auflageflächen (3131) von Außenrollen (313) auf. Die Auflageflächen (3131) weisen eine Neigung von 3°, sowie eine Breite von 10 mm auf. Das Substrat (1) wird mittig von einer ersten Innenrolle (314) gestützt, die eine Breite in der Auflagefläche von 3 mm aufweist. Das Substrat (1) wird nunmehr in der Heizkammer (3) auf seiner Ober- und seiner Unterseite beheizt und dabei langsam durch die Kammer bewegt (Vorschubgeschwindigkeit ca.: 1,5 m/min). Erreicht das Substrat (1) den Bereich der Transformationstemperatur, so sind von diesem Punkt an, auf den Wellen (31) wiederum mittig zwischen erster Innenrolle (314) und den Außenrollen (313), zwei zweite Innenrollen (314) angeordnet. Der Abstand der Führungsbünde (3132) beträgt nun 1206 mm. Das Heizsystem (34) wird nunmehr so eingestellt, dass das Substrat (1), wenn es das Ende der Heizkammer (3) erreicht auf seiner Unterseite um 6 K heißer ist als an seiner Oberseite. Diese Temperaturdifferenz führt zu einer inneren Spannung, die eine Wölbung des Substrats (1) zur Folge hat, deren Krümmungsmittelpunkt oberhalb des Substrats (1) liegt. Durch die Stützung mit drei Innenrollen (314) kann sich die Wölbung nicht ungehindert nach unten ausbilden. Es kommt zu einer Versteifung des Substrats (1). Aufgrund dieser Versteifung passiert das Substrat (1) den Wellenabstand von 250 mm in die nachfolgende Beschichtungskammer (2) ohne an die erste Welle (21) des Transportsystems (20) der Beschichtungskammer (2) anzustoßen. Das Transportsystem (20) der Beschichtungskammer (2) entspricht dem Transportsystem (30) der Heizkammer (3), nach dem Erreichen des Bereichs der Transformationstemperatur des Substrats (1). Das Substrat (1) wird weiter in Transportrichtung bewegt. Es erreicht den ersten Behälter (10), in dem CdS bei einer Temperatur von 680 °C verdampft wird. Das Substrat (1) wird in einem Abstand von 5 mm zur Kante über den Behälter (10) hinwegbewegt. Die Breite des Behälters (10) in Transportrichtung beträgt 300 mm. Da in diesem Bereich keine stützenden Rollen angeordnet werden können, überbrückt das Substrat (1) diesen Abstand lediglich aufgrund der inneren Spannung und der Aufwölbung, die aus der Temperaturdifferenz zwischen Unterseite und Oberseite des Substrats (1) resultiert. Hier kommt hinzu, dass aufgrund der hohen Temperatur im Behälter (10) die Unterseite weiterhin wesentlich stärker beheizt wird als die Oberseite. Die Unterseite des Substrats (1) erreicht dabei eine Temperatur von etwa 555°C. Nach dem Überwinden des ersten Behälters (10), wird das Substrat wieder von Wellen (21) mit zwei Außen- (213) und drei Innenrollen (214) gestützt. Nach drei dieser Wellen (21), die in einem Abstand von 250 mm angeordnet sind, folgt ein weiterer Beschichtungsbehälter (10) mit CdS. Dieser wird, ebenso wie die beiden folgenden Beschichtungsbehälter (10) mit CdTe, in der beschriebenen Weise überbrückt. Anschließend gelangt das beschichtete Substrat (1) in die zweite Heizkammer (3). Hier wird das Substrat langsam abgekühlt. Das Substrat verlässt die zweite Heizkammer mit einer Temperatur von etwa 500°C. Dieser zweiten Heizkammer nachgeschaltet, jedoch nicht näher beschrieben sind weitere Heizkammern, in denen die Substrattemperatur weiter sinkt. Nach dem Unterschreiten des Transformationsbereichs des Glases wird das Substrat (1) wieder auf Rollen (31) mit einem Abstand der Führungsbünde (3132) von 1205mm und einer einzigen Innenrolle (314) transportiert.

Figuren

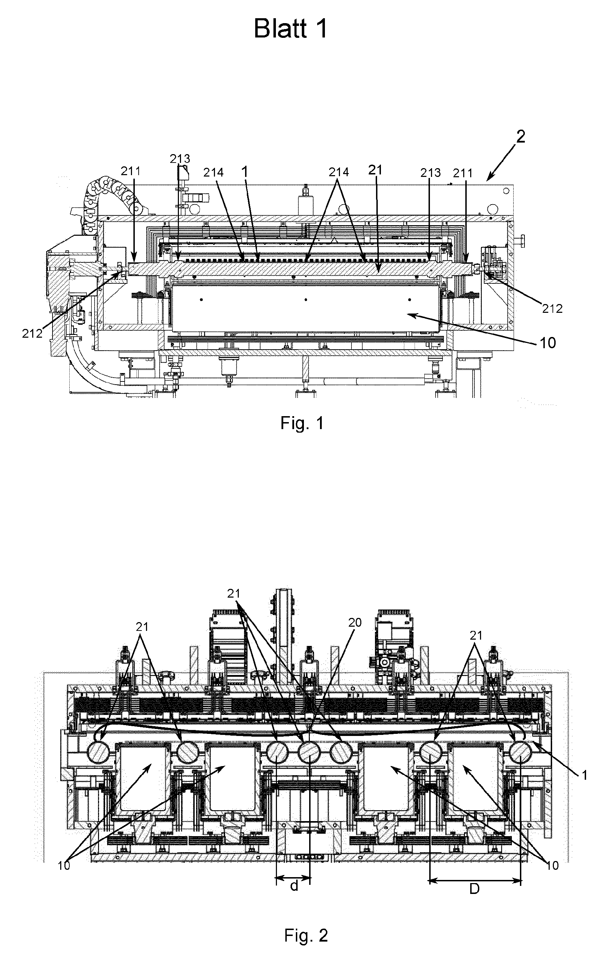

Fig. 1    zeigt einen Schnitt durch die Beschichtungskammer (2), der senkrecht zur Transportrichtung verläuft. Das Substrat (1) ist auf den Außenrollen (213) der Wellen (21) gelagert. zwischen den Außenrollen (213) wird das Substrat (1) von den Innenrollen (214) gestützt. Die Wellen (21) sind in der Nähe ihrer Enden (211) in Wellenlagern (212) gelagert.

**Fig. 2** zeigt einen senkrechten Schnitt durch die Beschichtungskammer (2) entlang der Transportrichtung. Die Wellen (21) gehören zum Transportsystem (20). An den Stellen, an denen die Behälter (10) mit Beschichtungsmaterial angeordnet sind ist der Abstand der Wellen (21) deutlich größer als in der Mitte der Beschichtungskammer (2), wo drei Wellen (21) gering beabstandet zueinander angeordnet sind.

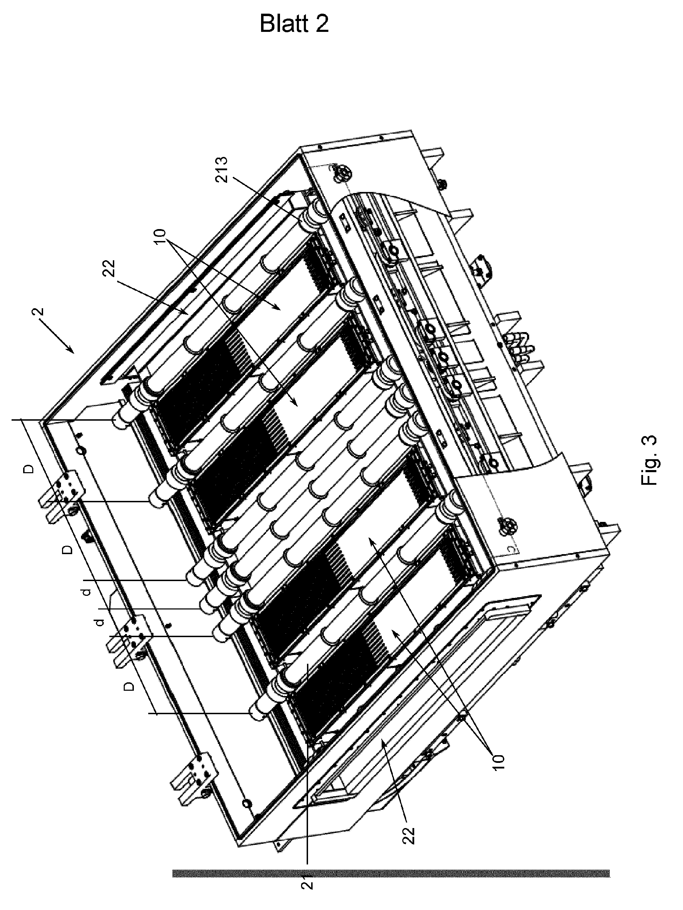

**Fig. 3** zeigt eine 3D Ansicht der Beschichtungskammer (2) mit entfernter oberer Abdeckung der Beschichtungskammer (2). Auch der obere Teil der inneren Kammer wurde entfernt. Zwischen den Wellen (21) sind die Behälter (10) mit Beschichtungsmaterial dargestellt. Der größere Abstand (D) der Wellen zwischen den Beschichtungsbehältern gegenüber dem geringeren Abstand (d) zwischen den direkt nebeneinander liegenden Wellen (21) in der Mitte der Beschichtungskammer (2) ist erkennbar. Das Substrat (1) tritt durch den Zufuhrschlitz (22) in die Beschichtungskammer (2) ein und wird von den Transportwellen (21) durch die Beschichtungskammer (2) bewegt. Durch den zweiten Zufuhrschlitz (22) verlässt das Substrat (1) die Beschichtungskammer (2) wieder.

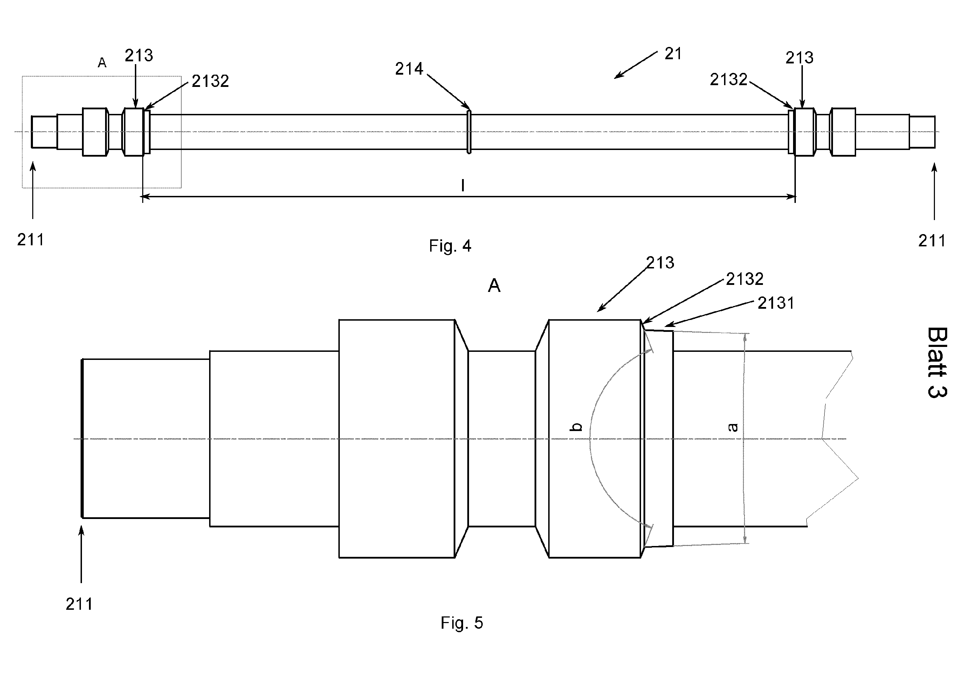

**Fig. 4** zeigt eine Welle (21) für den Temperaturbereich unterhalb der Transformationstemperatur des Substrats. Die Welle (21) weist daher nur eine Innenrolle (214) zwischen den Außenrollen (213) auf. Der Abstand (I) der Führungsbünde (2132) der Außenrollen (213) ist geringer als bei Wellen (21) nahe oder im Temperaturbereich der Transformationstemperatur des Substrats (1).

**Fig. 5** zeigt den Ausschnitt A der Fig. 4 aus der Welle (21), in dem das Wellenende (211) dargestellt ist, sowie der Führungsbund (2132) und die Auflagefläche (2131) der Außenrolle (213) dargestellt sind. Der Winkel (b) der Führungsbünde (2132) und der Winkel (a) der Auflageflächen wird wie dargestellt in einem Schnitt, der durch die Achse der Welle (21) gelegt ist, bestimmt.

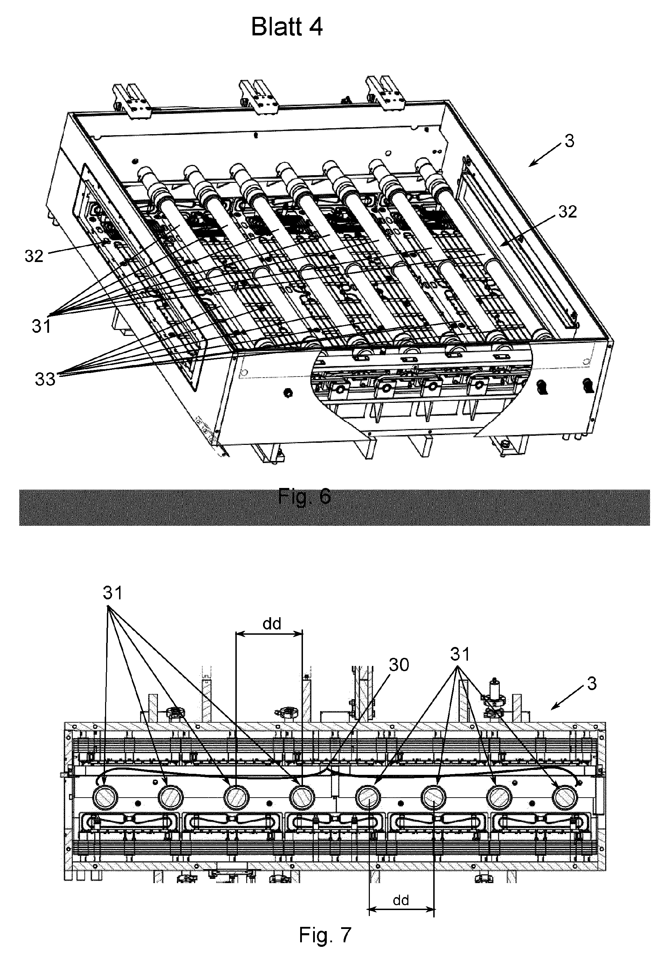

**Fig. 6** zeigt die 3D-Darstellung der Heizkammer (3) ohne ihren oberen Teil. In der Heizkammer (3) sind die Wellen (31) in gleichem Abstand voneinander angeordnet. Unter den Wellen (31) sind die Heizelemente (33) dargestellt. Das Substrat (1) tritt durch den Zufuhrschlitz (32) in die Heizkammer (3) ein und wird durch die Rollen (31) durch die Heizkammer bewegt, die es dann durch den zweiten Zufuhrschlitz (32) wieder verlässt.

**Fig. 7** zeigt einen Schnitt durch eine Heizkammer (3), der parallel zur Transportrichtung liegt. Das Transportsystem (30) der Heizkammer (3) weist die Wellen (31) auf. Der Abstand (dd) der Wellen zueinander ist für alle benachbarten Wellen gleich.

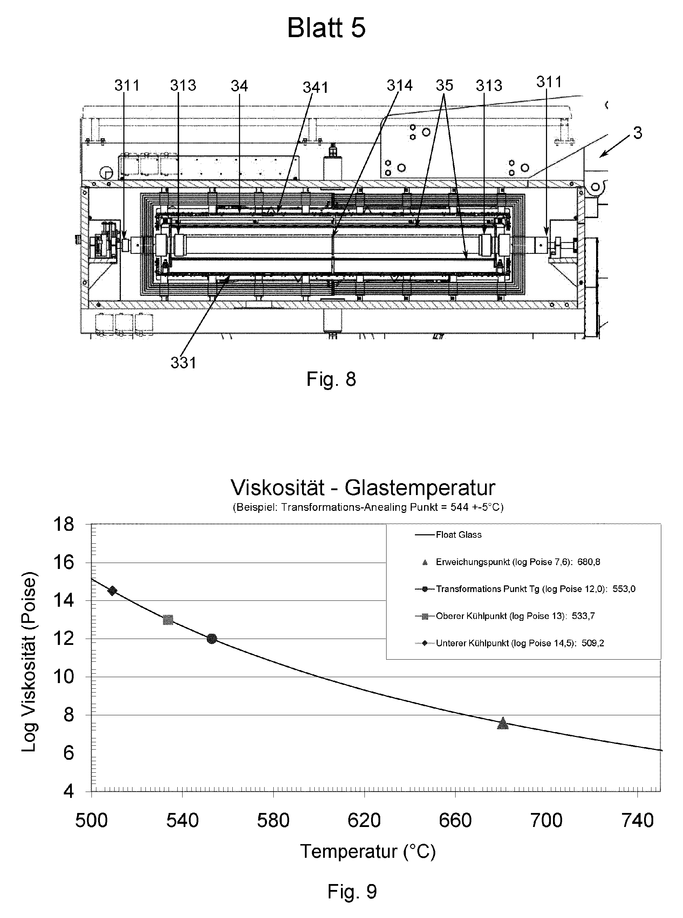

**Fig. 8** zeigt einen Schnitt durch die Heizkammer (3) senkrecht zur Transportrichtung. Die Wellen (31) weisen jeweils eine Innenrolle (314) zwischen zwei Außenrollen (313) auf. Die Wellen sind außerhalb der inneren Kammer (35) an ihren Enden (311) gelagert. Dargestellt sind die untere Reflexionsfläche (331) und die obere Reflexionsfläche (341), die die Wärmestrahlung des Heizsystems in Richtung des Substrats reflektieren. Es ist zu erkennen, dass die Reflexionsflächen seitlich heruntergezogen sind, um auch die Seitenkante des Substrats (1) erreichen zu können.

**Fig. 9** zeigt das Viskositätsverhalten eines Glassubstrats als Funktion der Temperatur. Erkennbar ist die Transformationstemperatur (553 °C), bei der ein Viskositätsexponent von 12,0 erreicht wird.

**Bezugszeichenliste**

| | |
|---|---|
| 1 | Substrat |
| 2 | Beschichtungskammer |
| 3 | Heizkammer |
| 10 | Behälter mit CdS oder CdTe |
| 20 | Transportsystem der Beschichtungskammer |
| 21 | Wellen des Transportsystems der Beschichtungskammer |
| 211 | Wellenenden der Wellen des Transportsystems der Beschichtungskammer |
| 212 | Wellenlager der Wellen des Transportsystems der Beschichtungskammer |
| 213 | Außenrollen der Wellen des Transportsystems der Beschichtungskammer |

| | |
|---|---|
| 2131 | konische Auflageflächen der Außenrollen der Wellen in der Beschichtungskammer |
| 2132 | geneigte Führungsbünde der Außenrollen der Wellen in der Beschichtungskammer |
| 214 | Innenrollen der Wellen des Transportsystems der Beschichtungskammer |
| 22 | Zufuhrschlitze der Beschichtungskammer |
| 30 | Transportsystem in der Heizkammer |
| 31 | Wellen des Transportsystems in der Heizkammer |
| 311 | Wellenenden der Wellen des Transportsystems der Heizkammer |
| 312 | Wellenlager der Wellen des Transportsystems der Heizkammer |
| 3131 | konische Auflageflächen der Außenrollen der Wellen in der Heizkammer |
| 3132 | Führungsbünde der Außenrollen der Wellen in der Heizkammer |
| 313 | Außenrollen der Wellen des Transportsystems der Heizkammer |
| 314 | Innenrollen der Wellen des Transportsystems der Heizkammer |
| 32 | Zufuhrschlitz der Heizkammer |
| 33 | Heizelemente des Heizsystems in der Heizkammer für die Unterseite des Substrats |
| 331 | Reflexionsflächen des Heizsystems der Unterseite |
| 34 | Heizelemente des Heizsystems in der Heizkammer für die Oberseite des Substrats |
| 341 | Reflexionsflächen des Heizsystems der Oberseite |
| 35 | Innere Kammer der Heizkammer |
| l | Abstand der Führungsbünde |
| a | Winkel der Auflagefläche der Außenrollen |
| b | Winkel der Führungsbünde |
| d | Abstand der Wellen in Bereichen der Beschichtungskammer in den keine Behälter angeordnet sind |
| dd | Abstand der Wellen in der Heizkammer |
| D | Abstand der Wellen in Bereichen der Beschichtungskammer in den Behälter angeordnet sind |

**Patentansprüche**

1. Verfahren, zur Beschichtung von plattenförmigen Substraten (1), gekennzeichnet durch die Schritte:

   a) Erwärmen des Substrats (1) auf Transformationstemperatur,
   b) zeitgleich und/oder nachfolgend zu a) Erwärmen der Unterseite des Substrats (1) auf eine höhere Temperatur als die Oberseite des Substrats,
   c) Aufdampfen von mindestens einem Beschichtungsmaterial auf das Substrat (1).

2. Verfahren nach Anspruch 1, **dadurch gekennzeichnet, dass** die Substrattemperatur nach Schritt c) unter die Transformationstemperatur abgesenkt wird und anschließend erneut die Verfahrensschritte a) bis c) ausgeführt werden.

3. Verfahren nach Anspruch 1 bis 2, **dadurch gekennzeichnet, dass** ein Substrat (1) eingesetzt wird, dessen Transformationstemperatur zwischen 540°C bis 570°C, bevorzugt zwischen 550°C und 560°C liegt.

4. Verfahren nach Anspruch 3, **dadurch gekennzeichnet, dass** das Substrat ein Natron-Kalk-Glas ist.

5. Verfahren nach Anspruch 4, **dadurch gekennzeichnet, dass** die Temperatur der Unterseite des Substrats (1) bei der Beschichtung größer 520°C ist, vorzugsweise zwischen 540°C und 570°C liegt und besonders bevorzugt 555°C beträgt.

6. Verfahren nach einem der Ansprüche 1 bis 5, **dadurch gekennzeichnet, dass** die Unterseite des Substrats (1) nach Schritt b) eine um mindestens 2 K bis 4 K, bevorzugt um 5 K bis 8 K, besonders bevorzugt um 6 K höhere Temperatur aufweist, als die Oberseite.

7. Verfahren nach einem der vorhergehenden Ansprüche, **dadurch gekennzeichnet, dass** es sich bei den Beschichtungsmaterialien um CdS und /oder CdTe oder aber um CIS oder CIGS (Kupfer, Indium und/oder Gallium, Selen) handelt.

8. Verfahren nach einem der vorhergehenden Ansprüche, **dadurch gekennzeichnet, dass** es sich bei den Beschichtungsmaterialien um CZTS (Kupfer, Zink und/oder Zinn, Schwefel) handelt.

9. Vorrichtung zur Ausführung des Verfahrens nach einem der vorhergehenden Ansprüche, die mindestens folgende Komponenten aufweist:

   • mindestens eine als Vakuumkammer ausgebildete Heizkammer (3), die mindestens zwei unabhängig voneinander steuer- oder regelbare Heizsysteme (33, 34) in einer inneren Kammer aufweist, wobei mindestens ein Heizsystem (34) die Oberseite und mindestens ein Heizsystem (33) die Unterseite des Substrats erhitzt, und die Heizsysteme (33, 34) so eingestellt sind, dass sie das Substrat (1) derart erhitzen, dass die Unterseite eine höhere Temperatur aufweist, als die Oberseite,
   • mindestens eine als Vakuumkammer ausgebildete und einer Heizkammer (3) in Transportrichtung nachgeordnete Beschichtungskammer (2) mit mindestens einem beheizbaren Verdampfertiegel mit Beschichtungsmaterial,
   • ein Transportsystem (30) für das Substrat (1), das sich durch die Heizkammer (3) und ein Transportsystem (20) für das Substrat (1), das sich durch die Beschichtungskammer (2) erstreckt, wobei beide Transportsysteme (20, 30) mehrere, parallele, axial beabstandete, in Transportrichtung hintereinander und senkrecht zu dieser, angeordnete Wellen (21, 31) aufweist, wobei jede Welle Außenrollen (213, 313) aufweist, zwischen denen jeweils mindestens eine Innenrolle (214, 314) angeordnet ist.

10. Vorrichtung nach Anspruch 9, **dadurch gekennzeichnet, dass** jede Heizkammer (3) und jede Beschichtungskammer (2) einen Substrateingang in die Kammer (2, 3), durch den das Substrat (1) ohne Schleusungsprozess aus einer vorgeordneten Kammer herein transportiert wird und einen Substratausgang aus der Kammer (2, 3), durch den das Substrat (1) ohne Schleusungsprozess in eine nachgeordnete Kammer hinaus transportiert wird, aufweist.

11. Vorrichtung nach Anspruch 9 oder 10, **dadurch gekennzeichnet, dass** die Außenrollen (213, 313) konische Auflageflächen (2131, 3131) für das Substrat (1) mit zum nächstgelegenen Wellenende (211, 311) hin zunehmendem Durchmesser aufweisen und dass die Auflageflächen (2131, 3131) eine Neigung von 1° bis 5°, bevorzugt 1° bis 2° aufweisen.

12. Vorrichtung nach einem der Ansprüche 9 bis 11, **dadurch gekennzeichnet, dass**, die Außenrollen (213, 313) geneigte Führungsbünde (2132, 3132) mit einer Neigung von 130° bis 150°, bevorzugt 139° aufweisen und dass die Führungsbünde (2132, 3132) die Auflageflächen (2131, 3131) der Außenrollen (213, 313) um mindestens 5 mm überragen.

13. Vorrichtung nach Anspruch 12, **dadurch gekennzeichnet, dass** die Wellen (21, 31), bei denen die Unterseitentemperatur des Substrats (1) im Bereich der Transformationstemperatur des Substrats (1) liegt, einen größeren Abstand der Führungsbünde (2132, 3132) aufweisen, als Wellen (21, 31), bei denen die Unterseitentemperatur des Substrats (1) unter der Transformationstemperatur liegt.

14. Vorrichtung nach einem der Ansprüche 9 bis 13, **dadurch gekennzeichnet, dass** die Wellen (21, 31), bei denen die Unterseitentemperatur des Substrats (1) im Bereich der Transformationstemperatur des Substrats (1) liegt, mehr Innenrollen (214, 314) aufweisen, als Wellen (21, 31), bei denen die Unterseitentemperatur des Substrats (1) unter der Transformationstemperatur liegt.

15. Vorrichtung nach einem der Ansprüche 9 bis 14, **dadurch gekennzeichnet, dass** die Innenrollen (214, 314) des Transportsystems (30) in Transportrichtung gesehen fluchtend angeordnet sind.

16. Vorrichtung nach einem der Ansprüche 9 bis 15, **dadurch gekennzeichnet, dass** der Radius der Außenkontur der Innenrolle (21, 31) im Auflagepunkt des Substrats (1) im Bereich von 1 mm bis 4 mm, bevorzugt bei 2 mm und die Breite der Innenrollen (214, 314) 2 mm bis 6 mm, vorzugsweise 3 mm bis 5 mm beträgt und/oder dass die Breite der Auflageflächen (2131, 3131) der Außenrollen (213, 313) 6 mm bis 12 mm, vorzugsweise 10 mm beträgt.

17. Vorrichtung nach einem der Ansprüche 9 bis 16, **dadurch gekennzeichnet, dass** der Antrieb der Wellen (21, 31) in den Vakuumkammern an wenigstens einem Ende (211, 311) jeder Welle (21, 31) sowie mittels einer direkten mechanischen Verbindung zur Welle (21, 31) erfolgt.

18. Vorrichtung nach einem der Ansprüche 9 bis 17, **dadurch gekennzeichnet, dass** die Heizsysteme (33, 34) der Heizkammer (3) als Heizschlangen ausgeführt sind, die schleifen-, mäander- oder zick-zack-förmig angeordnet sind, wobei das Heizsysteme (33, 34) für die Unterseite des Substrats unterhalb der Wellen (31) angeordnet ist.

**Claims**

1. Method for coating plate-shaped substrates (1), **characterised by** the steps:

   a) heating the substrate (1) to transformation temperature,
   b) simultaneously with and/or subsequent to a): heating the underside of the substrate (1) to a higher temperature than the upper side of the substrate,
   c) vapour deposition of at least one material to be deposited on the substrate (1).

2. Method according to claim 1, **characterised in that** the substrate temperature is lowered after step c) below the transformation temperature, and subsequently the process steps a) to c) are performed again.

3. Method according to claim 1 to 2, **characterised in that** a substrate (1) is used the transformation temperature of which is between 540°C and 570°C, and preferably between 550°C and 560°C.

4. Method according to claim 3, **characterised in that** the substrate is a lime soda glass.

5. Method according to claim 4, **characterised in that** the temperature on the underside of the substrate (1) during deposition is higher than 520°C, preferably between 540°C and 570°C, and particularly preferably 555°C.

6. Method according to any of the claims 1 to 5, **characterised in that** the underside of the substrate (1), after step b), has a temperature which is higher than that of the upper side by at least 2K to 4K, preferably by 5K to 8K, and particularly preferably by 6K.

7. Method according to any of the previous claims, **characterised in that** the materials to be deposited are CdS and/or CdTe or CIS or CIGS (copper, indium and/or gallium, selenium).

8. Method according to any of the previous claims, **characterised in that** the materials to be deposited are CZTS (copper, zinc and/or tin, sulphur).

9. Device for performing said method according to any of the previous claims, which device at least comprises the following components:

   • at least one heating chamber (3) executed as a vacuum chamber, which heating chamber has at least two heating systems (33, 34), which may be controlled or regulated independently of each other in an inner chamber, whereby at least one heating system (34) heats the upper side, and at least one heating system (33) heats the underside of the substrate, and whereby the heating systems (33, 34) are set accordingly to heat the substrate (1) so that the underside of the substrate has a higher temperature than the upper side,
   • at least one deposition chamber (2) executed as a vacuum chamber and positioned downstream in transport direction to a heating chamber (3) which deposition chamber has at least one heatable vaporization crucible with material to be deposited,
   • one transport system (30) for the substrate (1), which extends through the heating chamber (3), and one transport system (20) for the substrate (1), which extends through the deposition chamber (2), whereby both transport systems (20, 30) have several, parallel, axially spaced apart shafts (21, 31) arranged after one another in transport direction, and vertical to said transport direction, whereby each shaft has outer castors (213, 313), between each of which at least one inner castor (214, 314) is arranged.

10. Device according to claim 9, **characterised in that** each heating chamber (3) and each deposition chamber (2) have an entrance for the substrate into the chamber (2, 3), through which the substrate (1) is moved in without locking process from an upstream chamber, and an exit for the substrate from the chamber (2, 3), through which the substrate (1) is moved out without locking process into a downstream chamber.

11. Device according to claim 9 or 10, **characterised in that** the outer castors (213, 313) have conical contact areas (2131, 3131) for the substrate (1) with a diameter increasing towards the nearest shaft end (211, 311), and that the contact areas (2131, 3131) have an inclination angle of 1° to 5°, preferably of 1° to 2°.

12. Device according to one of the claims 9 to 11, **characterised in that** the outer castors (213, 313) have angled collars (2132, 3132) with an inclination angle of 130° to 150°, preferably of 139°, and that said collars (2132, 3132) project over the contact areas (2131, 3131) of the outer castors (213, 313) by at least 5 mm.

13. Device according to claim 12, **characterised in that** the shafts (21, 31), for which the temperature on the underside of the substrate (1) is in the range of the transformation temperature of the substrate (1), have a greater distance of the collars (2132, 3132) than those shafts (21, 31), for which the temperature on the underside of the substrate (1) is below the transformation temperature.

14. Device according to one of the claims 9 to 13, **characterised in that** the shafts (21, 31), for which the temperature on the underside of the substrate (1) is in the range of the transformation temperature of the substrate (1), have more inner castors (214, 314) than those shafts (21, 31), for which the temperature on the underside of the substrate (1) is below the transformation temperature.

15. Device according to one of the claims 9 to 14, **characterised in that** the inner castors (214, 314) of the transport system (30) are arranged in true alignment when seen in transport direction.

16. Device according to one of the claims 9 to 15, **characterised in that** the radius of the outer contour of the inner castors (214, 314) at the contact point of the substrate (1) is in the range of 1 mm to 4 mm, preferably 2 mm, and the width of the inner castors (214, 314) is 2 mm to 6 mm, preferably 3 mm to 5 mm and /or that the width of the contact areas (2131, 3131) of the outer castors (213, 313) is 6 mm to 12 mm, preferably 10 mm.

17. Device according to one of the claims 9 to 16, **characterised in that** the drive of the shafts (21, 31) in the vacuum chambers operates on at least one end (211, 311) of each shaft (21, 31) and by means of a direct mechanical connection to the shaft (21, 31).

18. Device according to one of the claims 9 to 17, **characterised in that** the heating systems (33, 34) of the heating chamber (3) are executed as heating coils which are arranged in the shape of loops, meanders or zigzags, whereby the heating system (33, 34) for the underside of the substrate is arranged below the shafts (31).

**Revendications**

1. Procédé pour revêtir des substrats (1) en forme de plaques, **caractérisé par** les étapes suivantes :

   a) chauffage du substrat (1) à une température de transformation,
   b) en même temps que a) ou à la suite de a), chauffage du dessous du substrat (1) à une température plus élevée que le dessus du substrat,
   c) dépôt en phase vapeur d'au moins un matériau de revêtement sur le substrat (1).

2. Procédé selon la revendication 1, **caractérisé en ce que** la température du substrat est abaissée à la suite de l'étape c) en dessous de la température de transformation, et on exécute ensuite à nouveau les étapes a) à c) du procédé.

3. Procédé selon la revendication 1 ou 2, **caractérisé en ce qu'**on utilise un substrat (1) dont la température de transformation est comprise entre 540 °C et 570 °C, de préférence entre 550 °C et 560 °C.

4. Procédé selon la revendication 3, **caractérisé en ce que** le substrat est un verre sodocalcique.

5. Procédé selon la revendication 4, **caractérisé en ce que** la température du dessous du substrat (1) lors du revêtement est supérieure à 520 °C, de préférence est comprise entre 540 °C et 570 °C, et d'une manière particulièrement préférée est égale à 555 °C.

6. Procédé selon l'une des revendications 1 à 5, **caractérisé en ce que** le dessous du substrat (1) présente à la suite de l'étape b) une température supérieure à celle du dessus d'au moins 2 K à 4 K, de préférence de 5 K à 8 K, d'une manière particulièrement préférée de 6 K.

7. Procédé selon l'une des revendications précédentes, **caractérisé en ce que** les matériaux de revêtement sont du CdS et/ou du CdTe ou bien du CIS ou du CIGS (cuivre, indium et/ou gallium, sélénium).

8. Procédé selon l'une des revendications précédentes, **caractérisé en ce que** les matériaux de revêtement sont du CZTS (cuivre, zinc et/ou étain, soufre).

9. Dispositif pour la mise en oeuvre du procédé selon l'une des revendications précédentes, qui présente au moins les composants suivants :

   - au moins une chambre de chauffage (3) conçue comme chambre à vide, qui présente dans une chambre intérieure au moins deux systèmes de chauffage (33, 34) pouvant être commandés ou régulés indépendamment entre eux, sachant qu'au moins un système de chauffage (34) chauffe le dessus et au moins un système de chauffage (33) le dessous du substrat, et que les systèmes de chauffage (33, 34) sont réglés de telle manière qu'ils chauffent le substrat (1) de telle sorte que le dessous présente une température supérieure à celle du dessus,
   - au moins une chambre de revêtement (2) conçue comme chambre à vide, disposée à la suite d'une chambre de chauffage (3) dans la direction de transport et pourvue d'au moins un creuset de vaporisation contenant du matériau de revêtement et pouvant être chauffé,
   - un système de transport (30) pour le substrat (1) qui s'étend à travers la chambre de chauffage (3) et un système de transport (20) pour le substrat (1) qui s'étend à travers la chambre de revêtement (2), sachant que les systèmes de transport (20, 30) présentent tous deux plusieurs arbres (21, 31) parallèles, axialement distants, disposés en succession dans la direction de transport et perpendiculairement à cette direction, sachant que chaque arbre présente des galets extérieurs (213, 313) entre lesquels est respectivement disposé au moins un galet intérieur (214, 314).

10. Dispositif selon la revendication 9, **caractérisé en ce que** chaque chambre de chauffage (3) et chaque chambre de revêtement (2) présente une entrée dans la chambre (2, 3) pour le substrat, par laquelle le substrat (1) est transporté dans cette chambre à partir d'une chambre en amont sans processus d'éclusage, et une sortie de la chambre (2, 3) pour le substrat, par laquelle le substrat (1) est évacué de cette chambre dans une chambre en aval sans processus d'éclusage.

11. Dispositif selon la revendication 9 ou 10, **caractérisé en ce que** les galets extérieurs (213, 313) présentent des surfaces de contact coniques (2131, 3131) pour le substrat (1) qui ont un diamètre augmentant en direction de l'extrémité d'arbre (211, 311) la plus proche, et **en ce que** les surfaces de contact (2131, 3131) présentent une inclinaison de 1° à 5°, de préférence de 1° à 2°.

12. Dispositif selon l'une des revendications 9 à 11, **caractérisé en ce que** les galets extérieurs (213, 313) présentent des collets de guidage inclinés (2132, 3132) ayant une inclinaison de 130° à 150°, de préférence de 139°, et **en ce que** les collets de guidage (2132, 3132) dépassent d'au moins 5 mm des surfaces de contact (2131, 3131) des galets extérieurs (213, 313).

13. Dispositif selon la revendication 12, **caractérisé en ce que** les arbres (21, 31) où la température du dessous du substrat (1) se situe au niveau de la température de transformation du substrat (1) présentent un plus grand espacement des collets de guidage (2132, 3132) que les arbres (21, 31) où la température du dessous du substrat (1) est inférieure à la température de transformation.

14. Dispositif selon l'une des revendications 9 à 13, **caractérisé en ce que** les arbres (21, 31) où la température du dessous du substrat (1) se situe au niveau de la température de transformation du substrat (1) présentent plus de galets intérieurs (214, 314) que les arbres (21, 31) où la température du dessous du substrat (1) est inférieure à la température de transformation.

15. Dispositif selon l'une des revendications 9 à 14, **caractérisé en ce que** les galets intérieurs (214, 314) du système de transport (30) sont disposés en alignement, considéré dans la direction de transport.

16. Dispositif selon l'une des revendications 9 à 15, **caractérisé en ce que** le rayon du contour extérieur des galets intérieurs (214, 314) au point de contact du substrat (1) est compris entre 1 mm et 4 mm, de préférence est égal à 2 mm et la largeur des galets intérieurs (214, 314) est comprise entre 2 mm et 6 mm, de préférence entre 3 mm et 5 mm, et/ou **en ce que** la largeur des surfaces de contact (2131, 3131) des galets extérieurs (213, 313) est comprise entre 6 mm et 12 mm, de préférence est égale à 10 mm.

17. Dispositif selon l'une des revendications 9 à 16, **caractérisé en ce que** l'entraînement des arbres (21, 31) dans les chambres à vide s'effectue à au moins une extrémité (211, 311) de chaque arbre (21, 31) et au moyen d'une liaison mécanique directe vers l'arbre (21, 31).

**18.** Dispositif selon l'une des revendications 9 à 17, **caractérisé en ce que** les systèmes de chauffage (33, 34) de la chambre de chauffage (3) sont réalisés sous la forme de serpentins de chauffage qui sont disposés en boucles, en méandres et/ou en zigzag, sachant que le système de chauffage (33, 34) pour le dessous du substrat est disposé en dessous des arbres (31).

# Blatt 1

Fig. 1

Fig. 2

Blatt 2

Fig. 3

Fig. 4

Fig. 5

# Blatt 4

Fig. 6

Fig. 7

# Blatt 5

Fig. 8

## Viskosität - Glastemperatur

(Beispiel: Transformations-Anealing Punkt = 544 +-5°C)

Legend:
- —— Float Glass
- ▲ Erweichungspunkt (log Poise 7,6): 680,8
- ●— Transformations Punkt Tg (log Poise 12,0): 553,0
- ■— Oberer Kühlpunkt (log Poise 13): 533,7
- ◆— Unterer Kühlpunkt (log Poise 14,5): 509,2

Log Viskosität (Poise)

Temperatur (°C)

Fig. 9

**IN DER BESCHREIBUNG AUFGEFÜHRTE DOKUMENTE**

**In der Beschreibung aufgeführte Patentdokumente**

- WO 03054975 A2
- WO 2010012890 A2